# FASCICULE DE BREVET EUROPEEN

(11) **EP 1 214 462 B1**
(45) Date de publication et mention de la délivrance du brevet: **12.03.2003**
(21) Numéro de dépôt: 00960790.4
(22) Date de dépôt: 04.09.2000
(51) Int. Cl.: C30B 25/10, C23C 16/26

(54) **PROCEDE DE FABRICATION D'UNE PIECE METALLIQUE RECOUVERTE DE DIAMANT ET PIECE METALLIQUE OBTENUE AU MOYEN D'UN TEL PROCEDE**
VERFAHREN ZUR HERSTELLUNG EINES DIAMANT-BESCHICHTETEN METALLISCHEN GEGENSTANDES UND SOLCHER GEGENSTAND SO HERGESTELLT
METHOD FOR MAKING A METAL PART COATED WITH DIAMOND AND METAL PART OBTAINED BY SAID METHOD

(30) Priorité: 03.09.1999 FR 9911110; 18.11.1999 FR 9914498
(43) Date de publication de la demande: 19.06.2002
(73) Titulaire: Vandenbulcke, Lionel, 45100 Orléans (FR); De Barros, Maria Isabel, 45000 Orléans (FR)
(72) Inventeur: Vandenbulcke, Lionel, 45100 Orléans (FR); De Barros, Maria Isabel, 45000 Orléans (FR)
(74) Mandataire: Flavenot, Bernard
(86) Numéro de dépôt international: FR0002436
(87) Numéro de publication internationale: WO01018284

(56) Documents cités:
- EP-A- 0 738 787
- MITURA E ET AL: "The properties of carbon layers deposited onto titanium substrates" DIAMOND AND RELATED MATERIALS,NL,ELSEVIER SCIENCE PUBLISHERS, AMSTERDAM, vol. 5, no. 9, 1 juillet 1996 (1996-07-01), pages 998-1001, XP004080610 ISSN: 0925-9635
- LEE J ET AL: "NUCLEATION AND BULK FILM GROWTH KINETICS OF NANOCRYSTALLINE DIAMONDPREPARED BY MICROWAVE PLASMA-ENHANCED CHEMICAL VAPOR DEPOSITION ON SILICON SUBSTRATES" APPLIED PHYSICS LETTERS,US,AMERICAN INSTITUTE OF PHYSICS. NEW YORK, vol. 69, no. 12, 16 septembre 1996 (1996-09-16), pages 1716-1718, XP000629172 ISSN: 0003-6951
- CHEN K H ET AL: "HIGHLY TRANSPARENT NANO-CRYSTALLINE DIAMOND FILMS VIA SUBSTRATE PRETREATMENT AND METHANE FRACTION OPTIMIZATION" THIN SOLID FILMS,CH,ELSEVIER-SEQUOIA S.A. LAUSANNE, vol. 332, no. 1/02, 2 novembre 1998 (1998-11-02), pages 34-39, XP000669209 ISSN: 0040-6090

## Description

La présente invention concerne un procédé de fabrication d'une pièce métallique revêtue d'une couche de diamant ainsi que la pièce métallique obtenue au moyen d'un tel procédé de fabrication.

Plus particulièrement, l'invention se rapporte à un procédé de fabrication d'une pièce en titane ou en alliage de titane revêtue d'une couche de diamant nanocristallin ainsi qu'à une pièce en titane obtenue par ce procédé de fabrication. L'expression « diamant nanocristallin » désigne un diamant dont les grains ont une taille morphologique de l'ordre de 1 à 50 nanomètres et qui présente une faible rugosité de surface, inférieure à 30nm environ, indépendante de l'épaisseur de la couche de diamant.

Le titane présente une très bonne immunité biologique et est donc largement utilisé dans le domaine biomédical.

Les alliages de titane présentent de bonnes caractéristiques mécaniques, notamment une bonne résistance à la traction, à la fatigue, à la corrosion, une bonne tenue au fluage et une masse volumique relativement faible. Ces alliages sont donc largement utilisés dans les domaines aéronautique et spatial.

Les alliages de titane ont pour constituant principal le titane allié à d'autres éléments en plus faible concentration. Un alliage très couramment utilisé est l'alliage connu sous la dénomination alliage « TA6V ».

Cependant, le titane et les alliages de titane ont une mauvaise résistance à l'usure, en particulier lorsqu'ils sont en contact avec un métal ou un alliage métallique, et un coefficient de frottement élevé avec un grand nombre de matériaux.

Pour augmenter la résistance à l'usure et améliorer l'immunité biologique suivant l'utilisation voulue, il est connu de déposer sur le titane ou les alliages de titane une couche de carbone, par exemple sous forme de couche de diamant.

Le but de la présente invention est d'obtenir des couches de diamant nanocristallin de rugosité faible adhérant parfaitement sur des substrats métalliques tels que des alliages de titane ou des substrats revêtus de titane ou d'un alliage de titane déposé lors d'une opération préalable.

Un autre but de la présente invention est d'effectuer le dépôt des couches de diamant à température modérée comprise entre 400°C et 600°C.

Le brevet français FR 2 733 255 divulgue un procédé de fabrication d'une pièce métallique en titane ou en alliage de titane revêtue d'une couche de diamant polycristallin obtenue en déposant, à une température comprise entre 400°C et 700°C, une couche d'accrochage du diamant comportant au moins 10% de carbone graphitique ou amorphe, puis le revêtement de diamant obtenu à partir d'un mélange gazeux comprenant du méthane et de l'hydrogène ou préférentiellement du monoxyde de carbone et de l'hydrogène. La couche de diamant obtenue présente une épaisseur de 1 à 10µm sans écaillage.

Cependant, ce procédé présente l'inconvénient de conduire à la formation d'une couche polycristalline de rugosité élevée dépendant de l'épaisseur de la couche. Or, une rugosité plus faible confère des propriétés tribologiques meilleures en limitant l'abrasion des pièces antagonistes. De meilleurs résultats sont également obtenus lors du frottement de deux pièces antagonistes revêtues de diamant. Les coefficients de frottement et les usures sont plus faibles. De plus, la faible rugosité permet de limiter les pressions de contact locales initiales très élevées qui sont produites lorsque des couches de diamant polycristallin classique sont utilisées. Ces pressions de contact locales conduisent à des contraintes de cisaillement internes importantes qui peuvent déformer le substrat et diminuer la tenue de la couche de diamant polycristallin.

Le brevet américain US 5 772 760 décrit un procédé de dépôt sur des plaquettes de silicium de films de diamant nanocristallin présentant des grains de taille pouvant descendre jusqu'à 15nm, tout en conservant une bonne. qualité de diamant, comme en attestent les études réalisées en spectroscopie Raman et microscopie électronique à transmission. Ces films sont déposés à une température comprise entre 470°C et 850°C, à partir de mélanges gazeux contenant, d'une part, un fullérène en C₆₀, un hydrocarbure tel que CH₄, C₂H₂ ou l'anthracène ou un mélange de ceux-ci et, d'autre part, un gaz inerte, essentiellement de l'argon, auquel on peut ajouter de l'hydrogène. Cependant, dans les exemples cités(cf. tableau I), la température du substrat est toujours égale à 850°C pour obtenir de faibles rugosités comprises entre 30 et 50nm. Michler et al. décrivent dans J. Crystal Growth, 172, 1997, pp. 404-415 la fabrication de films de diamant à partir d'un mélange gazeux CH₄ + CO₂. Il est indiqué que pour des températures de 400°C à 600°C, la taille des grains est supérieure à 200nm.

Chen et al. mentionnent, dans Diamond and Relat. Mater., 3, 1994, pp.443-447, que l'on peut obtenir des films de diamant de très bonne qualité à partir du mélange CH₄+CO₂ en opérant à la température de 820°C. Des dépôts de diamant de moins bonne qualité sont obtenus à température beaucoup plus basse, dans la gamme de 220°C à 340°C. Même dans ces conditions de dépôt à basse température, la taille des grains qui a diminué est encore dans la gamme de 50 à 1000nm.

On ne peut donc pas déduire de ces deux publications que l'on peut obtenir des couches de diamant nanocristallin à partir de mélanges de CH₄ et de CO₂, en opérant à température modérée.
De manière surprenante, on a obtenu un dépôt de couches de diamant nanocristallin de rugosité faible, à température modérée, sur des substrats métalliques tels que des alliages de titane ou des substrats revêtus de titane ou d'un alliage de titane.

Pour ce faire, l'invention a pour objet un procédé de fabrication d'une pièce métallique revêtue d'une couche de diamant, du type comportant les étapes consistant à :
- fabriquer un substrat métallique comprenant une surface à revêtir dont le constituant principal est le titane,
- déposer, dans une première étape, sur la surface à revêtir une couche de carbone d'accrochage du diamant comportant au moins 10% de carbone graphitique et amorphe et destinée à diffuser en partie ou entièrement dans la surface à revêtir pendant une deuxième étape,
- déposer, dans la deuxième étape, le revêtement de diamant sur la couche d'accrochage,
ce procédé étant caractérisé en ce que le revêtement de diamant est une couche de diamant nanocristallin obtenu à partir d'un mélange gazeux constitué de carbone, d'oxygène et d'hydrogène dans des proportions telles que le rapport O/H soit supérieur à 0,5 et le rapport O/C supérieur à 1.

Selon un mode de réalisation, le mélange gazeux comprend, en outre, un gaz rare.

Préférentiellement, le mélange gazeux est constitué de méthane et de dioxyde de carbone dans un rapport CH₄/CO₂ inférieur à 1.

En variante, on peut utiliser un mélange constitué par de l'acétylène et du dioxyde de carbone dans un rapport C₂H₂/CO₂ inférieur à 0,5.

Un mode de réalisation consiste à fabriquer le substrat en titane ou en alliage de titane.

Au cours de l'étape de fabrication du substrat métallique, on dépose sur une masse métallique une couche contenant du titane.

Selon une variante de réalisation, on dépose sur la masse métallique, préalablement au dépôt de la couche contenant du titane, une couche réfractaire destinée à former une barrière de diffusion du carbone dans le substrat métallique.

La couche réfractaire peut être constituée de nitrure de titane, de nitrure de vanadium, de niobium, de tungstène, de tantale, de molybdène ou d'un alliage comportant un élément choisi parmi ce groupe.

La masse métallique peut être également constituée d'un acier ou d'un carbure cémenté.

Les deux étapes de dépôt de la pré-couche et de la couche de diamant sont réalisées à une température comprise entre 400°C et 850°C et, de préférence, entre 400°C et 700°C.

La pièce métallique obtenue par le procédé selon l'invention possède une couche de diamant nanocristallin d'une épaisseur comprise entre 1 et 10µm.

Cette couche présente les caractéristiques suivantes :
- une structure générale d'apparence colonnaire,
- une sous-structure constituée de grains de diamant de taille inférieure à environ 50nm,
- une rugosité de surface inférieure à environ 30nm ou à la rugosité initiale du substrat et qui n'évolue pas avec l'épaisseur de diamant déposé.

D'autres caractéristiques et avantages ressortiront de la description suivante, en regard des dessins ci-après.

La figure 1 représente un dispositif destiné à effectuer un dépôt selon l'invention.

La figure 2 représente une section transversale d'une couche de diamant nanocristallin selon l'invention déposée sur un alliage de titane.

La figure 3 représente la variation, en fonction de l'épaisseur déposée, de la rugosité des couches de diamant nanocristallin selon l'invention.

La figure 4 représente la variation, en fonction de l'épaisseur déposée, de la rugosité des couches de diamant polycristallin selon le brevet français FR 2 733 255.

La figure 5 représente un diagramme de rayons X en incidence rasante d'une couche de diamant nanocristallin déposée sur l'alliage TA6V selon le procédé de l'invention.

La figure 6 représente un spectre de perte d'énergie des électrons réalisé sur une lame mince préparée dans une section transversale d'une couche de diamant nanocristallin selon l'invention.

La figure 7 représente un spectre Raman d'une couche de diamant nanocristallin selon l'invention.

La figure 8 représente les spectres d'émission obtenus avec :
- 2cm³/mn de méthane dans 75cm³/mn d'argon (fig. 8A)
- 2cm³/mn de méthane dans 200cm³/mn d'hydrogène (fig. 8B)
- 15cm³/mn de monoxyde de carbone dans 180cm³/mn d'hydrogène (fig. 8C)
- 26cm³/mn de méthane dans 37cm³/mn de dioxyde de carbone (fig. 8D).

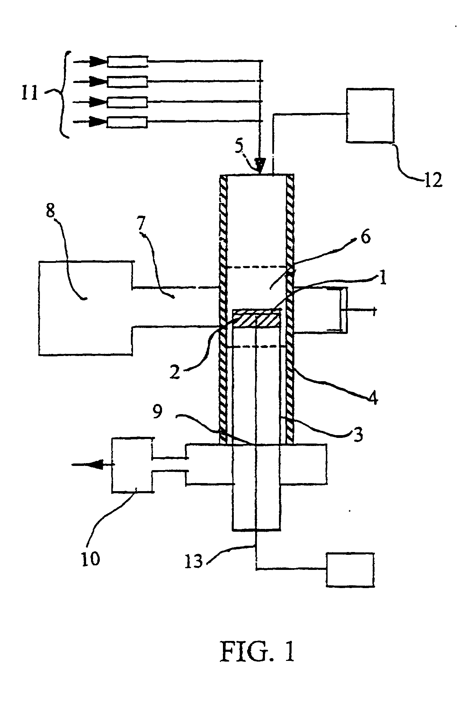

La figure 1 représente un dispositif de dépôt chimique assisté par plasma à micro-ondes (PACVD). Il est destiné à déposer une couche de diamant nanocristallin 1 sur un substrat 2 disposé sur un support 3. Le dispositif PACVD comporte une enceinte en silice 4 munie d'une ouverture 5 pour l'alimentation en gaz d'une zone de dépôt 6 où est produit le plasma par l'intermédiaire d'un guide d'onde 7 relié à un générateur de micro-ondes 8. Les gaz ressortent de l'enceinte par une ouverture 9. L'enceinte est reliée de façon connue à une pompe à vide 10. Par ailleurs, le dispositif PACVD comporte des moyens d'adaptation connus permettant de régler la position du plasma devant le substrat à revêtir et de limiter la puissance réfléchie vers le générateur de micro-ondes. Le dispositif PACVD est complété par des moyens d'adaptation , un système de régulation des débits des différents gaz 11, de contrôle 12 et régulation de la pression, de type connu. Un thermocouple 13 placé à 0,5mm en dessous de la surface à revêtir permet de mesurer la température de dépôt.

Les substrats peuvent être notamment des substrats métalliques. Le substrat métallique 2 est constitué d'un alliage de titane de type TA6V. Le dispositif PACVD permet de déposer sur le substrat métallique 2, éventuellement préalablement décapé par décapage ionique, une couche de diamant nanocristallin 1 à des températures comprises entre 400°C et 700°C.

A l'issue du dépôt du diamant nanocristallin sur le substrat métallique, une couche fine de carbure de titane est formée sous la couche de diamant, dont l'épaisseur dépend des conditions de dépôt, durée et température.

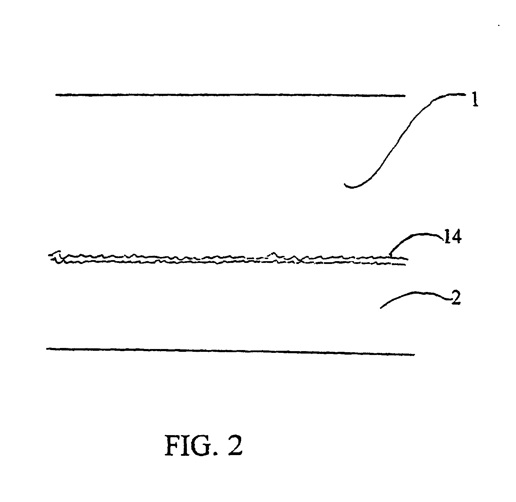

La figure 2 montre que le substrat métallique en TA6V ainsi revêtu comporte une couche de diamant nanocristallin 1 adhérant à l'alliage de titane 2 par l'intermédiaire d'une couche de carbure de titane 14.

En variante, on fabrique un substrat métallique en déposant, de manière connue, une couche de titane ou d'un alliage de titane sur une masse métallique. Ensuite, on dépose une couche de diamant nanocristallin sur ce substrat métallique selon le procédé de l'invention.

La masse métallique peut comporter, en outre, une couche réfractaire destinée à jouer le rôle de barrière de diffusion pour le carbone qui est déposé sur la masse métallique préalablement au dépôt de la couche de titane ou d'alliage de titane. La couche réfractaire est en nitrure de titane, nitrure de vanadium, niobium, tantale, tungstène, et molybdène ou en alliage incluant un de ces éléments. La masse métallique est constituée de titane ou d'un alliage de titane. Elle peut être constituée également d'un acier ou d'un carbure cémenté. Dans ce dernier cas, la masse métallique étant constituée d'une couche de carbure cémenté, le dépôt de la pré-couche et de la couche de diamant nanocristallin peut être effectué dans une gamme de température plus large, comprise entre 400 et 850°C.

Les couches de diamant selon l'invention de 2µm d'épaisseur ont une rugosité mise en évidence au microscope à force atomique (AFM) de 25nm, tandis que les couches de diamant polycristallin selon le brevet français FR 2 733 255 de même épaisseur ont une rugosité de 100nm. Ceci met en évidence l'avantage du procédé selon l'invention qui permet de déposer des couches de diamant nanocristallin beaucoup moins rugueuses que les couches de diamant polycristallin. Cette faible rugosité leur confère, en frottement, un caractère beaucoup moins abrasif vis-à-vis de la surface antagoniste. Des coefficients de frottement et usures plus faibles en résultent, que ce soit en frottement de la couche de diamant nanocristallin sur antagoniste différent ou sur antagoniste revêtu d'une couche de diamant nanocristallin.

Les couches de diamant nanocristallin selon l'invention ont de plus l'avantage de présenter une rugosité constante quelle que soit l'épaisseur des couches déposées.

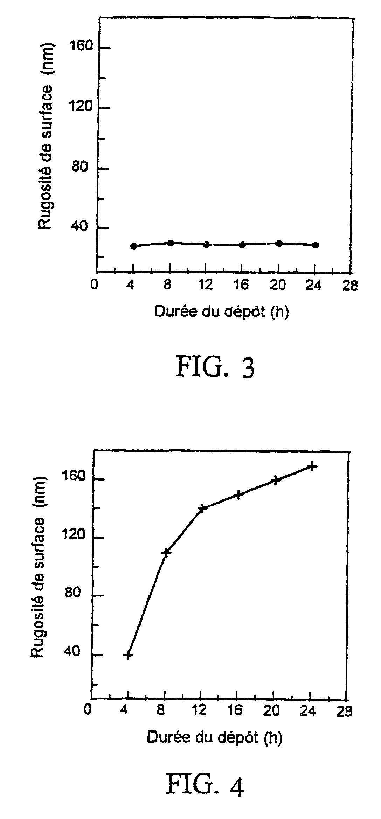

La figure 3 montre une variation nulle, en fonction de l'épaisseur déposée, de la rugosité des couches de diamant nanocristallin selon l'invention.

La figure 4 montre la variation importante, en fonction de l'épaisseur déposée, de la rugosité des couches de diamant polycristallin selon le brevet français FR 2 733 255.

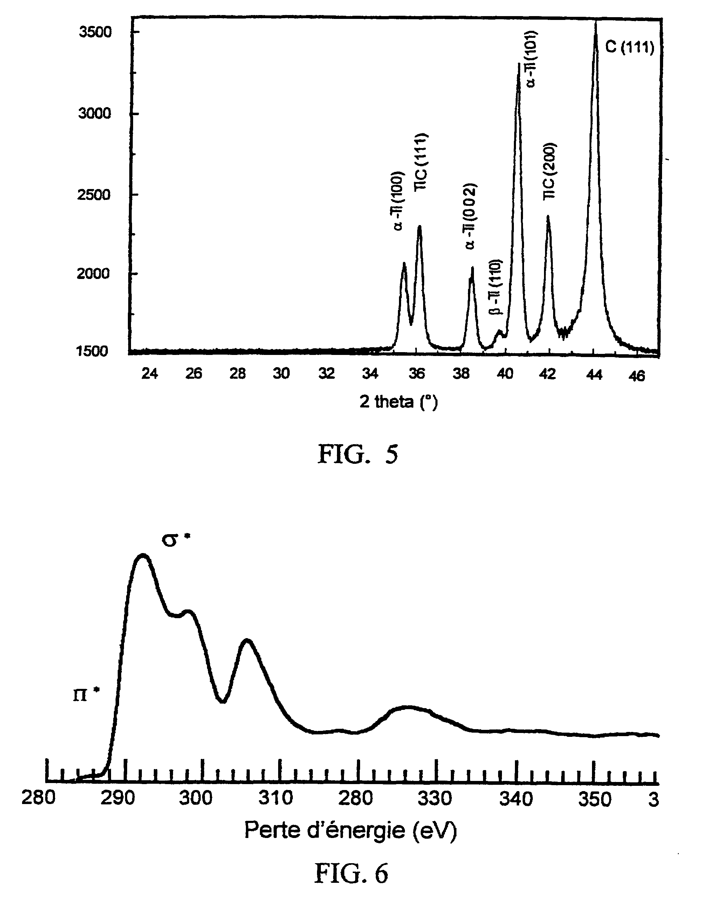

Les couches de diamant nanocristallin selon l'invention sont de bonne qualité, c'est-à-dire qu'elles comportent un taux d'incorporation de carbone non-diamant faible comme le montrent les figures 5, 6 et 7.

La figure 5 est un diagramme de rayons X d'une couche de diamant nanocristallin déposée selon le procédé de l'invention. Celui-ci ne met en évidence que les raies du diamant, en dehors des raies du substrat métallique en alliage de titane (α-Ti et β-Ti) et des raies du carbure de titane TiC.

La figure 6 représente un spectre de perte d'énergie des électrons réalisé sur une lame mince préparée dans une section transversale d'une couche de diamant nanocristallin selon l'invention. La structure de ce spectre est caractéristique du diamant cristallisé sans mise en évidence d'un pic de transition 1s-π* au pied du seuil C-K du carbone à 285eV, pic de transition caractéristique du carbone polyaromatique ou graphitique.

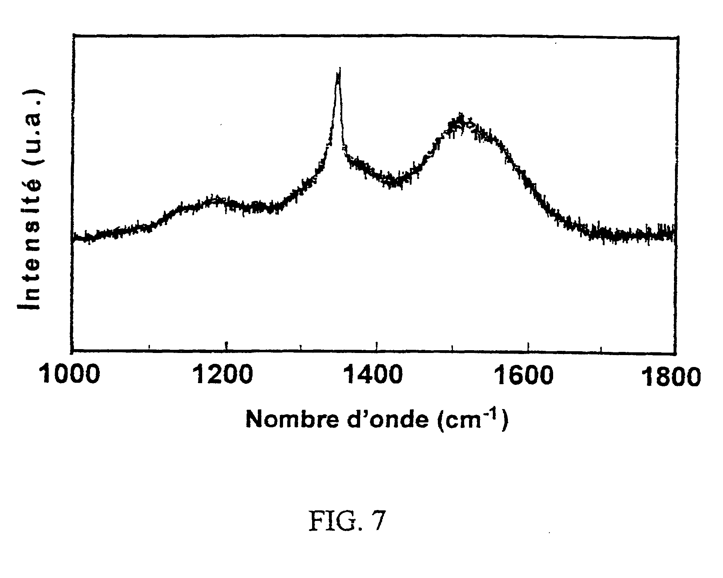

La figure 7 représente un spectre Raman d'une couche de diamant nanocristallin selon l'invention. Ce spectre Raman comporte le pic classique du diamant vers 1330-1340cm⁻¹, en fonction des contraintes résiduelles dans la couche de diamant et des bandes additionnelles vers 1200cm⁻¹ correspondant au diamant désorganisé et vers 1350, 1500 et 1560cm⁻¹ qui correspondent à l'incorporation de quantités faibles de carbone amorphe et polyaromatique. Les sections efficaces de ces carbones non-diamant sont en effet environ 75 fois plus grandes que celles du diamant cristallisé, ce qui conduit à la mise en évidence de quantités incorporées faibles. Ce spectre Raman peut être comparé à celui représenté dans le brevet américain US 5 722 760. Dans ce dernier brevet, on montre que le dépôt de diamant nanocristallin est obtenu essentiellement lorsque le spectre d'émission met en évidence une présence importante des raies de C₂.

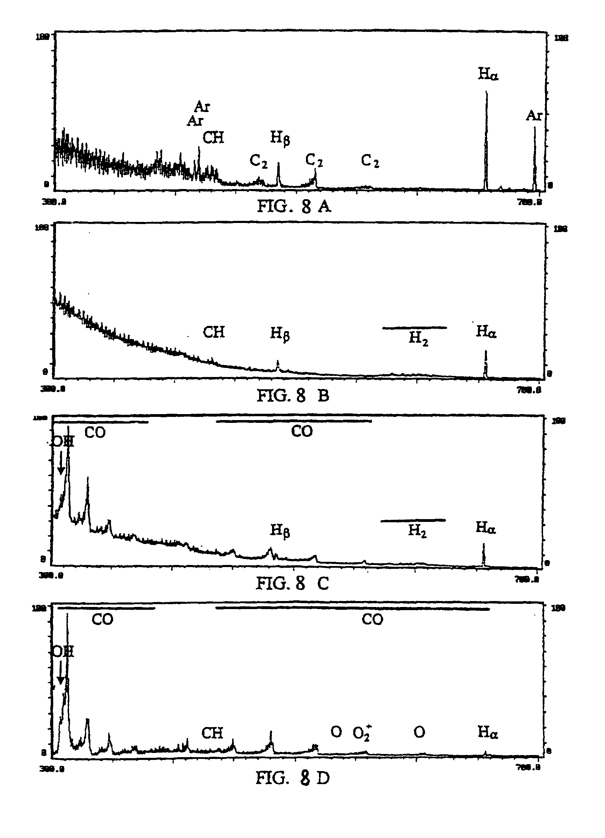

La figure 8A montre un spectre d'émission enregistré lors du dépôt d'une couche de diamant nanocristallin selon le procédé du brevet américain US 5 722 760 (2cm³/mn de méthane dans 75cm³/mn d'argon). Les raies de C₂ y sont bien présentes avec celles de H_{α} et H_{β} et celles de Ar.

La figure 8B représente un spectre d'émission enregistré lors du dépôt d'une couche de diamant polycristallin (2cm³/mn de méthane dans 200cm³/mn d'hydrogène). Sur ce spectre n'apparaît que CH en plus des raies de l'hydrogène, H₂, H_{α} et H_{β}.

La figure 8C montre le spectre d'émission obtenu à partir d'un mélange conduisant à un dépôt de diamant polycristallin selon le brevet français FR 2 733 255 (10cm³/mn de monoxyde de carbone dans 180cm³/mn d'hydrogène). Ce dernier met, en plus, en évidence les raies de CO et celle de OH.

La figure 8D montre le spectre d'émission correspondant à un plasma obtenu à partir d'un mélange de 26cm³/mn de méthane dans 37cm³/mn de dioxyde de carbone selon l'invention. Les espèces contenant de l'oxygène apparaissent plus nettement que sur la figure 8C au détriment des raies de l'hydrogène, H₂, H_{α} et H_{β}.

Il est clair que le processus de dépôt du diamant nanocristallin selon l'invention ne met pas en jeu l'espèce prépondérante C₂ comme dans le brevet US 5 772 760. On utilise des mélanges gazeux tels que CH₄+CO₂, C₂H₂+CO₂ et, plus généralement, des mélanges gazeux qui contiennent les éléments C, H et O avec un rapport O/H plus grand que 0,5 et un rapport O/C supérieur à 1 dans le mélange introduit, conditions telles qu'il n'y ait pas d'émission importante des espèces hydrogénées mais émission des espèces contenant de l'oxygène. Il en résulte un diamant nanocristallin de nature différente de celle du brevet américain, avec une structure générale d'apparence colonnaire, tandis que le diamant obtenu selon le procédé du brevet américain présente une structure polynucléée avec des grains de forme sphérique.

Afin d'illustrer l'objet de l'invention, quelques exemples non limitatifs sont décrits ci-après.

### EXEMPLE 1 :

Un dépôt de diamant nanocristallin est réalisé avec le dispositif de la figure 1 sur un substrat en alliage de titane TA6V suivant deux étapes successives qui peuvent être séparées ou non par un retour à la température ambiante.

Dans une première étape, on dépose une couche de carbone comportant au moins 10% de carbone graphitique et amorphe, dans les conditions suivantes :
- débit d'hydrogène égal à 180cm³/mn
- débit de méthane égal à 28cm³/mn,
- puissance micro-ondes égale à 1100W,
- pression égale à 133,3Pa (10 torr),
- température égale à 600°C,
- durée du dépôt égale à 2 heures.

Dans une deuxième étape, on dépose une couche de diamant nanocristallin sur le substrat revêtu de la pré-couche, dans les conditions suivantes :
- débit de méthane égal à 26cm³/mn,
- débit de dioxyde de carbone égal à 37cm³/mn,
- puissance micro-ondes égale à 850W,
- pression égale à 133,3Pa (10 torr),
- température égale à 600°C,
- durée du dépôt égale à 8 heures.

On obtient ainsi un substrat en alliage de titane, représenté sur la figure 2, dont la structure de l'alliage n'a pas été modifiée par le traitement à 600°C et revêtu d'une couche de diamant nanocristallin d'épaisseur environ 2µm. La rugosité de surface de cette couche est de 25nm.

Deux couches de ce type ayant été déposées sur un pion et un disque en alliage TA6V, le coefficient de frottement mesuré à l'aide d'un tribomètre pion-disque est inférieur à 0,1, après une courte période d'accommodation des deux surfaces.

### EXEMPLE 2 :

Un dépôt de diamant nanocristallin est réalisé dans les conditions opératoires de l'exemple 1 avec les différences ci-après :
- durée de dépôt pour la première étape égale à 3 heures,
- durée de dépôt pour la deuxième étape égale à 30 heures .
On obtient ainsi un substrat en alliage de titane, dont la structure de l'alliage n'a pas été modifiée par le traitement à 600°C et revêtu d'une couche de diamant nanocristallin d'épaisseur environ 8µm. La rugosité de surface de cette couche est de 20nm.

Deux couches de ce type ayant été déposées sur un pion et un disque en alliage TA6V, le coefficient de frottement mesuré à l'aide d'un tribomètre pion-disque est inférieur à 0,1, après une courte période d'accommodation des deux surfaces.

### EXEMPLE 3 :

Un dépôt de diamant nanocristallin est réalisé à l'aide du dispositif de la figure 1 sur un substrat en acier de type Z80WCDV revêtu préalablement par dépôt physique à partir de la phase gazeuse (PVD), suivant une méthode connue, d'une couche de nitrure de titane de 2µm d'épaisseur constituant une barrière de diffusion pour le carbone, puis d'une couche de titane de 3µm d'épaisseur, suivant deux étapes successives.

Les conditions opératoires sont celles de l'exemple 1, avec les différences suivantes :
- température de dépôt de la première étape égale à 580°C,
- température de dépôt de la deuxième étape égale à 580°C,
- débit de méthane dans la deuxième étape égal à 30cm³/mn.

On obtient ainsi un substrat métallique constitué d'une masse métallique en acier Z80WCDV, dont la structure de l'acier n'a pas été modifiée par le traitement à 580°C et revêtu d'une couche de diamant nanocristallin d'épaisseur environ 2µm avec en sous-couche une couche de carbure de titane d'épaisseur environ 200nm, puis une couche de titane et une couche de nitrure de titane. La rugosité de surface de cette couche est de 25nm.

Deux couches de ce type ayant été déposées sur un pion et un disque en Z80WCDV, le coefficient de frottement mesuré à l'aide d'un tribomètre pion-disque est inférieur à 0,1, après une courte période d'accommodation des deux surfaces.

### EXEMPLE 4 :

Un dépôt de diamant nanocristallin est réalisé à l'aide du dispositif de la figure 1 sur un substrat en alliage de titane de type TA6V, suivant deux étapes successives qui peuvent être séparées ou non par un retour à la température ambiante.

Les conditions opératoires de la première étape sont identiques à celles de l'exemple 1.

Dans une deuxième étape, on dépose une couche de diamant nanocristallin sur le substrat revêtu de la pré-couche dans les conditions suivantes :
- débit d'acétylène égal à 20cm³/mn,
- débit de dioxyde de carbone égal à 57cm³/mn,
- puissance micro-ondes égale à 850W,
- pression égale à 133,3Pa (10 torr),
- température égale à 600°C,
- durée du dépôt égale à 8 heures.

On obtient ainsi un substrat en alliage de titane, dont la structure de l'alliage n'a pas été modifiée par le traitement à 600°C et revêtu d'une couche de diamant nanocristallin d'épaisseur environ 2µm. La rugosité de surface de cette couche est de 20nm.

Deux couches de ce type ayant été déposées sur un pion et un disque en alliage TA6V, le coefficient de frottement mesuré à l'aide d'un tribomètre pion-disque est inférieur à 0,1, après une courte période d'accommodation des deux surfaces.

### EXEMPLE 5:

Un dépôt de diamant polycristallin, selon le procédé du brevet français 2 733 255, est réalisé à l'aide du dispositif de la figure 1 sur un substrat en alliage de titane de type TA6V, suivant deux étapes successives qui peuvent être séparées ou non par un retour à la température ambiante.

Dans une première étape, on dépose une couche de carbone comportant au moins 10% de carbone graphitique ou amorphe, dans les conditions suivantes :
- débit d'hydrogène égal à 200cm³/mn
- débit de méthane égal à 12cm³/mn,
- puissance micro-ondes égale à 400W,
- pression égale à 333,3Pa (2,5 torr),
- température égale à 600°C,
- durée du dépôt égale à 3 heures.

Dans une deuxième étape, on dépose une couche de diamant polycristallin sur le substrat revêtu de la pré-couche, dans les conditions suivantes :
- débit d'hydrogène égal à 180cm³/mn,
- débit de monoxyde de carbone égal à 15cm³/mn,
- puissance micro-ondes égale à 400W,
- pression égale à 133,3Pa (10 torr),
- température égale à 600°C,
- durée du dépôt égale à 8 heures.

On obtient ainsi un substrat en alliage de titane, dont la structure de l'alliage n'a pas été modifiée par le traitement à 600°C et revêtu d'une couche de diamant polycristallin d'épaisseur environ 2µm. La rugosité de surface de cette couche est de 100nm.

Deux couches de ce type ayant été déposées sur un pion et un disque en alliage TA6V, le coefficient de frottement mesuré à l'aide d'un tribomètre pion-disque est inférieur à 0,2, après une période d'accommodation des deux surfaces environ 3 fois plus longue que dans les exemples précédents.

Il ressort de ces exemples que les couches de diamant nanocristallin ont une rugcsité beaucoup plus faible que les couches de diamant polycristallin. Les périodes d'accommodation observées lors du frottement de ces couches sont beaucoup plus courtes et les usures beaucoup plus faibles. Ceci est encore plus évident lors du frottement d'un matériau beaucoup moins dur que le diamant sur ces couches. C'est ainsi que la période d'accommodation d'un pion en alliage de titane sur une couche de diamant nanocristallin de rugosité de 20nm est 5 à 10 fois plus courte que sur une couche de diamant polycristallin de rugosité de 100nm et son usure en volume est divisée par un facteur 20 par rapport au frottement sur une couche polycristalline, dans les mêmes conditions de distance parcourue et de charge appliquée.

Par ailleurs, une image au microscope électronique à balayage (MEB) à 15kV d'une couche de diamant nanocristallin après un test de frottement d'un pion en TA6V revêtu de diamant nanocristallin sur un disque en TA6V revêtu de diamant nanocristallin, effectué pendant 10km, dans l'air ambiant, sous une charge de 13N ( le rayon de courbure du pion est de 10mm) montre une zone polie avec des grains fins. Après le même test effectué avec deux antagonistes en TA6V revêtus de diamant polycristallin, l'image MEB réalisée dans les mêmes conditions à 15kV montre une déformation de l'alliage de titane, vue à travers la couche de carbone diamant, avec des stries perpendiculaires à la direction de glissement dues aux contraintes de cisaillement induites, au début du test, par des pressions locales de contact très élevées, lorsque les couches sont encore très rugueuses.

On peut donc conclure que les couches de diamant nanocristallin selon l'invention présentent des avantages très importants par rapport aux couches polycristallines pour les applications mécaniques. En variante, le procédé selon l'invention permet de revêtir des substrats en carbures cémentés jusqu'à une température de 850°C. Les outils de coupe ainsi revêtus voient l'accumulation de la matière usinée diminuer par rapport à ce qui est obtenu avec des couches polycristallines plus rugueuses, ce qui permet d'augmenter la durée de vie des outils en carbures cémentés revêtus et d'améliorer l'état de surface de la pièce usinée. Bien entendu les avantages des couches de diamant nanocristallin démontrés en mécanique ne sauraient limiter leurs applications à ce seul domaine.

Parmi les autres applications, on peut citer l'émission électronique des couches nanocristallines déposées sur des substrats variés à une température comprise entre 400 et 600°C.

## Revendications

1. Procédé de fabrication d'une pièce métallique revêtue d'une couche de diamant, du type comportant les étapes consistant à :
- fabriquer un substrat métallique comprenant une surface à revêtir dont le constituant principal est le titane,
- déposer, dans une première étape, sur la surface à revêtir une couche de carbone d'accrochage du diamant comportant au moins 10% de carbone graphitique et amorphe et destinée à diffuser en partie ou entièrement dans la surface à revêtir pendant une deuxième étape,
- déposer, dans la deuxième étape, le revêtement de diamant sur la couche d'accrochage,
ce procédé étant **caractérisé en ce que** le revêtement de diamant est une couche de diamant nanocristallin obtenu à partir d'un mélange gazeux constitué de carbone, d'oxygène et d'hydrogène dans des proportions telles que le rapport O/H soit supérieur à 0,5 et le rapport O/C supérieur à 1.

2. Procédé selon la revendication 1, **caractérisé en ce que** le mélange gazeux comprend, en outre, un gaz rare.

3. Procédé selon la revendication 1 ou 2, **caractérisé en ce que** le mélange gazeux est constitué de méthane et de dioxyde de carbone dans un rapport CH₄/CO₂ inférieur à 1.

4. Procédé selon la revendication 1 ou 2, **caractérisé en ce que** le mélange gazeux est constitué d'acétylène et de dioxyde de carbone dans un rapport C₂H₂/CO₂ inférieur à 0,5.

5. Procédé selon l'une quelconque des revendications précédentes, **caractérisé en ce que** les deux étapes de dépôt de carbone sont réalisées à une température comprise entre 400 et 850°C.

6. Procédé selon la revendication 5, **caractérisé en ce que** les deux étapes de dépôt de carbone sont réalisées à une température comprise entre 400 et 700°C.

7. Procédé selon la revendication 1, **caractérisé en ce que** l'on fabrique le substrat en titane ou en alliage de titane.

8. Procédé selon la revendication 1, **caractérisé en ce que**, au cours de l'étape de fabrication du substrat métallique, on dépose sur une masse métallique une couche contenant du titane.

9. Procédé selon la revendication 8, **caractérisé en ce que** l'on dépose sur la masse métallique, préalablement au dépôt de la couche contenant du titane, une couche réfractaire destinée à former une barrière de diffusion du carbone dans le substrat métallique.

10. Procédé selon la revendication 9, **caractérisé en ce que** la couche réfractaire est constituée de nitrure de titane, de nitrure de vanadium, de niobium, de tungstène, de tantale, de molybdène ou d'un alliage comportant un élément choisi parmi ce groupe.

11. Procédé selon la revendication 8, **caractérisé en ce que** la masse métallique est constituée d'un acier ou d'un carbure cémenté.

12. Pièce métallique comprenant un substrat revêtu d'une couche de diamant nanocristallin obtenue par le procédé de l'une quelconque des revendications précédentes.

## Claims

1. A method of manufacturing a piece of metal coated in a layer of diamond, the method being of the type comprising the steps consisting in:
· fabricating a metal substrate having a surface for coating, the main component of which is titanium;
· in a first step, depositinq a diamond-bonding carbon layer on the surface to be coated, the carbon layer comprising at least 10% graphitic and amorphous carbon and being intended to diffuse in full or in part into the surface to be coated during a second step;
· in the second step, depositing the diamond coating on the bonding layer;
the method being **characterized it that** the diamond coating is a layer of nanocrystalline diamond obtained from a gaseous mixture constituted by carbon, oxygen, and hydrogen in proportions such that the O/H ratio is greater than 0.5, and the O/C ratio is greater than 1.

2. A method according to claim 1, **characterized it that** the gaseous mixture further comprises a rare gas.

3. A method according to claim 1 or claim 2, **characterized in that** the gaseous mixture is constituted by methane and carbon dioxide with a CH₄/CO₂ ratio of less than 1.

4. A method according to claim 1 or claim 2, **characterized in that** the gaseous mixture is constituted by acetylene and carbon dioxide with a C₂H₂/CO₂ ratio of less than 0.5.

5. A method according to any preceding claim, **characterized it that** the two carbon-depositing steps are performed at a temperature lying in the range 400°C to 850°C.

6. A method according to claim 5, **characterized in that** the two carbon-depositing steps are performed at a temperature lying in the range 400°C to 700°C.

7. A method according to claim 1, **characterized in that** the substrate is made of titanium or a titanium alloy.

8. A method according to claim 1, **characterized in that** during the step of fabricating the metal substrate, a layer containing titanium is deposited on a metal mass.

9. A method according to claim 8, **characterized in that** prior to depositing the titanium-containing layer, a refractory layer is deposited on the metal mass to form a barrier against carbon diffusing into the metal substrate.

10. A method according to claim 9, **characterized in that** the refractory layer is constituted by titanium nitride, vanadium nitride, niobium, tungsten, tantalum, molybdenum, or an alloy including an element selected from said group.

11. A method according to claim 8, **characterized in that** the metal mass is constituted by a steel or a metal carbide.

12. A metal piece comprising a substrate coated in a nanocrystalline diamond layer obtained by the method according to any preceding claim.

## Patentansprüche

1. Verfahren zum Herstellen eines mit einer Diamantschicht beschlchteten Metallteils des Typs, der die Schritte umfaßt, die darin bestehen:
- ein metallisches Substrat herzustellen, das eine zu beschichtende Oberfläche besitzt und dessen Hauptbestandteil Titan ist;
- in einem ersten Schritt auf der zu beschichtenden Oberfläche eine Kohlenstofflage für die Diamantverankerung abzulagern, die wenigstens 10 % graphitischen und amorphen Kohlenstoff enthält und dazu bestimmt ist, in die zu beschichtenden Oberfläche während eines zweiten Schrittes teilweise oder vollständig zu diffundieren,
- in dem zweiten Schritt die Diamantbeschichtung auf der Verankerungsschicht abzulagern,
wobei das Verfahren **dadurch gekennzeichnet ist, daß** die Diamantbeschichtung eine nanokristalline Diamantschicht ist, die aus einem gasförmigen Gemisch erhalten wird, das aus Kohlenstoff, Sauerstoff und Wasserstoff in solchen Anteilen besteht, daß das Verhältnis O/H größer als 0,5 ist und das Verhältnis O/C größer als 1 ist.

2. Verfahren nach Anspruch 1, **dadurch gekennzeichnet, daß** das gasförmige Gemisch außerdem ein Edelgas enthält.

3. Verfahren nach Anspruch 1 oder 2, **dadurch gekennzeichnet, daß** das gasförmige Gemisch aus Methan und Kohlendioxid in einem Verhältnis CH₄/CO₂ kleiner als 1 besteht.

4. Verfahren nach Anspruch 1 oder 2, **dadurch gekennzeichnet, daß** das gasförmige Gemisch aus Acetylen und Kohlendioxid in einem Verhältnis C₂H₂/CO₂ kleiner als 0,5 gebildet ist.

5. Verfahren nach einem der vorhergehenden Ansprüche, **dadurch gekennzeichnet, daß** die beiden Schritte des Ablagerns von Kohlenstoff bei einer Temperatur im Bereich von 400 bis 850 °C ausgeführt werden.

6. Verfahren nach Anspruch 5, **dadurch gekennzeichnet, daß** die beiden Schritte der Kohlenstoffablagerung bei einer Temperatur im Bereich von 400 bis 700 °C ausgeführt werden.

7. Verfahren nach Anspruch 1, **dadurch gekennzeichnet, daß** das Substrat aus Titan oder aus einer Titanlegierung hergestellt ist.

8. Verfahren nach Anspruch 1, **dadurch gekennzeichnet, daß** während des Schrittes der Herstellung des metallischen Substrats auf einer metallischen Masse eine titanhaltige Lage abgelagert wird.

9. Vertahren nacn Anspruch 8, dadurch gekennzelchnet, daß auf der metallischen Masse vor der Ablagerung der titanhaltigen Lage eine hitzebeständige Lage abgelagert wird, die dazu bestimmt ist, eine Diffusionsbarriere für Kohlenstoff in das metallische Substrat zu bilden.

10. Verfahren nach Anspruch 9, **dadurch gekennzeichnet, daß** die hitzebeständige Lage aus Titannitrid, Vanadiumnitrid, Niobnitrid, Wolframnitrid, Tantalnitrid, Molybdännitrid oder aus einer Legierung, die ein aus dieser Gruppe gewähltes Element enthält, gebildet ist.

11. Verfahren nach Anspruch 8, **dadurch gekennzeichnet, daß** die metallische Masse aus einem Stahl oder einem Sinterhartmetall gebildet ist.

12. Metallisches Teil, das ein Substrat umfaßt, das mit einer nanokristallinen Diamantschicht beschichtet ist, die durch das Verfahren nach einem der vorhergehenden Ansprüche erhalten wird.
